# EUROPÄISCHE PATENTSCHRIFT

(11) **EP 2 422 585 B1**
(45) Veröffentlichungstag und Bekanntmachung des Hinweises auf die Patenterteilung: **10.07.2013**
(21) Anmeldenummer: 10718869.0
(22) Anmeldetag: 20.04.2010
(51) Int. Cl.: H01L 51/44, H05B 33/28, H05B 33/14

(54) **OPTOELEKTRONISCHE FOLIENANORDNUNG**
OPTOELECTRONIC FILM ASSEMBLY
DISPOSITIF DE FEUILLES OPTOÉLECTRONIQUE

(30) Priorität: 20.04.2009 DE 102009017787
(43) Veröffentlichungstag der Anmeldung: 29.02.2012
(73) Patentinhaber: Sefar AG, Thal, 9425 Thal/SG (CH)
(72) Erfinder: CHABRECEK, Peter, CH-9306 Freidorf (CH); MEIER, Hanspeter, CH-9112 Schachen (CH); LANTUS, Muriel, CH-9000 St. Gallen (CH); SONDEREGGER, Uriel, CH-9015 St. Gallen Winkeln (CH)
(74) Vertreter: Wagner, Kilian
(86) Internationale Anmeldenummer: PCT/EP2010/002410
(87) Internationale Veröffentlichungsnummer: WO 2010/121785

(56) Entgegenhaltungen:
- WO-A1-2005/062679
- WO-A1-2009/060717
- WO-A1-2010/051976

## Beschreibung

Die vorliegende Erfindung betrifft eine optoelektronische Folienanordnung, insbesondere Elektrolumineszenz-(EL-) Folie, nach dem Oberbegriff des Hauptanspruchs.

Derartige Vorrichtungen sind aus dem Stand der Technik allgemein bekannt und werden aufgrund ihrer günstigen flächigen Leuchteigenschaften in Verbindung mit niedriger Stromaufnahme und langer Leuchtzeit in verschiedensten Anwendungsgebieten, vor allem zur Realisierung von Warn- oder Signalflächen in Beleuchtung, Werbung, Design und Architektur, eingesetzt.

Flächige, folienartige Elektrolumineszenz-Vorrichtungen basieren auf dem Funktionsprinzip, dass in der Art eines Plattenkondensators zwischen zwei flächigen Elektroden eine so genannte aktive Schicht, typischerweise aus dotiertem Zinksulfid als elektrolumineszentem Material bestehend, sowie eine Dielektrikumsschicht vorgesehen ist und diese Anordnung bei Bestromung mit einem Wechselspannungssignal (typische Frequenz zwischen ca. 200 Hz und 4 kHz) eine kalte, flächige und ungerichtete Lichtemission durchführt. Amplitude und Frequenz der angelegten Wechselspannung können die Helligkeit (und in Grenzen auch die Farbe) der Lichtemission verändern.

In der konstruktiven Realisierung weisen aus dem Stand der Technik bekannte EL-Folienanordnungen nach dem Oberbegriff des Hauptanspruchs typischerweise als erste Elektrode ein Polymer-Substrat auf, welches mit Indiumzinnoxid (indium tin oxide ITO, als Realisierung eines lichtdurchlässigen, leitfähigen Oxids (TCO)), typischerweise durch Vakuumsputtern, so beschichtet ist, dass eine leitende, gleichwohl lichtdurchlässige Elektrodenschicht entsteht. Darauf ist, in Richtung auf eine gleichermaßen flächige und typischerweise lichtundurchlässige, etwa mittels einer Leiterplatte realisierte Gegenelektrode, eine aktive Schicht aus elektrolumineszentem Material vorgesehen, typischerweise durch Verwendung von Zinksulfit, welches mit geeigneten Metallen wie Gold, Silber, Kupfer, Gallium oder Mangan dotiert ist. Eine darauf aufgebrachte dielektrische Schicht, beispielsweise Bariumtitanat, verhindert ein Kurzschließen der Elektroden, wenn die (typischerweise lichtundurchlässige) Gegenelektrode die gattungsgemäß bekannte Folienanordnung komplettiert.

Aus dem Stand der Technik bekannt ist es zudem, die aktive Schicht und/oder die dielektrische Schicht durch ein Siebdruckverfahren aufzubringen, wobei geeignet pastöse, für den Siebdruck vorgesehene Schichtmaterialien handelsüblich sind und etwa von Herstellern wie Dupont angeboten werden.

WO 2005/062679 A1 weist eine Folienanordnung auf, die beinhaltend zwei Elektrodenschichten, eine dazwischen liegende Dielektrikumsschicht und eine Dielektrikumsschicht benachbarte, aktive Schicht. Bei der Folienanordnung können beide Elektrodenschichten, die weder TCO noch ITO enthalten und aus einem elektrisch leitfähige Fasern aufweisendem Gewebe bestehen, lichtdurchlässig sein.

Insbesondere bei der Großserienfertigung derartiger optoelektronischer Folienanordnungen erweist sich die.transparente ITO-PET-Frontelektrode als kostenkritisch, noch dazu ist sie brüchig. ITO muss ferner als sehr dünne Schicht aufgetragen werden, um hinreichend optisch transparent zu sein, dadurch leidet wiederum die elektrische Leitfähigkeit (und liegt damit typischerweise höher als 50Ω/sq, weist damit nicht unerhebliche elektrische Widerstandseigenschaften auf). Hieraus ergehen sich wiederum mehrere Nachteile: zunächst benötigen auf ITO basierende Leuchtmittel eine (typischerweise mittels Silber oder Silberdruck realisierte) Strom- bzw. Anschlussschiene, um den elektrischen Anschluss sicherzustellen. Damit liegt dann bereits zu diesem Zeitpunkt eine Dimension des Produktes fest, sodass etwa ein kontinuierlicher, endloser Herstellungsprozess (mit den entsprechenden Kosten- und Mengenvorteilen) ausscheidet. Auch liegt in diesen geometrischen Vorgaben das Problem begrenzter Abmessungen, mit welchen gleichmäßige Helligkeit erreicht wird, und durch die beschriebene Struktur ist eine maximale Grenzfrequenz zum Ansteuern beschränkt.

Entsprechend besteht der Bedarf nach alternativen, mechanisch verbesserten und potenziell preisgünstigen (und gleichwohl das Realisieren einer transparenten flächigen Elektrode ermöglichenden) Materialien, die zudem in ihren elektrischen bzw. Widerstandseigenschaften verbessert sind und geringere Anforderungen an die Kontaktierung aufweisen.

Aufgabe der vorliegenden Erfindung ist es daher, eine alternative Folienanordnung zur Realisierung einer Elektrolumineszenz-Folie zu schaffen, welche insbesondere im Hinblick auf den Herstellungsaufwand sowie die Notwendigkeit teurer Materialien zur Realisierung einer transparenten Elektrodenfläche optimiert ist. Ferner ist ein neues bzw. verbessertes Verfahren zum Herstellen einer EL-Folienanordnung zu schaffen.

Die Aufgabe wird durch die optoelektronische Folienanordnung mit den Merkmalen des Hauptanspruchs, das Verfahren zum Herstellen einer optoelektronischen Folienanordnung mit den Merkmalen des unabhängigen Patentanspruchs 7 sowie eine Verwendung der optoelektronischen Folienanordnung zur Herstellung von Leucht- und/oder Signalvorrichtungen für die Unterhaltungs - und/oder Haushaltselektronik, das Bau-, Messe-, Architektur-, Sicherheits - und/oder Verkehrswesen, eingeschlossen Luftverkehrswesen gelöst. Vorteilhafte Weiterbildungen der Erfindung sind in den Unteransprüchen beschrieben.

In erfindungsgemäß vorteilhafter Weise weist mindestens eine der beiden Elektrodenschichten, oder beide, ein Gewebe auf, welches elektrisch leitende Fasern aufweist.

Dieses Gewebe bietet damit die Möglichkeit, effizient und kostengünstig die Elektrodenfunktionalität zu realisieren, wobei gleichzeitig -- durch geeignete Ausgestaltung des Gewebes bei der Wahl der jeweiligen Fiberdicke, der Ausgestaltung der Zwischenräume zwischen den Fibern und der Art der elektrisch leitenden Fasern (Fibern) -- in sehr flexibler Weise Möglichkeiten zur Ausgestaltung der gewünschten Eigenschaften und zur Anpassung an einen jeweils beabsichtigten Einsatzzweck der optoelektronischen Folienanordnung ermöglicht werden. Zudem ist diese Anordnung flexibel und nahezu beliebig formbar.

So ist es zunächst bevorzugt, zur Stabilisierung und zum Schutz des Gewebes gegen Feuchtigkeits- oder andere Umgebungseinflüsse, dieses (zumindest teilweise) in ein transparentes, elektrisch nicht-leitendes Polymermaterial einzubetten. Auf diese Weise kann nicht nur (etwa durch geeignete Einfärbung dieses Polymermaterials) die Lichtfarbe beeinflusst werden, auch ist, durch geeignete Auswahl des Polymermaterials, die Elektrode (und damit die Gesamtanordnung) witterungsbeständig realisierbar.

Zur praktischen Umsetzung der Beschichtung für die Fasern ist es im Rahmen bevorzugter Weiterbildungen der Erfindung möglich, diese in Form eines strahlenhärtenden, ergänzend oder alternativ, thermisch härtenden Harzes auszugestalten, wobei ein Acrylharz, ein Silikonmaterial, ein Fluorpolymer geeignet sein kann, ebenso wie ein Polymer, ausgewählt aus einer Gruppe, bestehend aus PU, PEN, PI, PET, PA, EVA oder vergleichbaren Materialien.

Im Hinblick auf die erfindungsgemäßen Fasern (Fibern) ist es zunächst von der Erfindung umfasst, das Gewebe im Wesentlichen aus elektrisch nicht-leitenden Fasern herzustellen, welche dann zur Realisierung der Elektrodenwirkung mit einer elektrischen Leitfähigkeit versehen werden. Geeignete Fasern (Fibern) sind insbesondere transparente oder semitransparente Monofilamente von PA, PP, PET, PEEK, PI, PPS oder dergleichen Chemiefasern. Dies ermöglicht im Vergleich zu reinen Metallfasern (bei vergleichbaren elektrischen Leitungseigenschaften) signifikante Kostenvorteile; besonders drastisch werden zudem diese Kostenvorteile realisiert im Vergleich zu der gattungsgemäßen ITO-Beschichtung.

Zum Herstellen der elektrischen Leitfähigkeit, wobei bevorzugt das eingesetzte Gewebe einen Flächenwiderstand < 50Ω/sq, bevorzugt < 20Ω/sq, weiter bevorzugt kleiner 10Ω/sq, aufweist, ist es einerseits von der Erfindung umfasst, weiterbildungsgemäß Fasern im Gewebe vorzusehen, welche aus Metall bestehen (Metallfasern), oder als Fasern, die eine Metallisierung tragen. Vorteilhaft weist die Metallisierung eine Schichtdicke im Bereich zwischen 100nm und 10µm, insbesondere zwischen 200nm und 3µm auf. Geeignete Metalle zur Realisierung der metallisierten oder der Metallfasern sind etwa Ti, Ag, Al, Cu, Au, Pa, Pt, Ni, W, Mo, Nb, Ba, Sn, Zr od.dgl., wobei die Leitfähigkeit des Gewebes (bzw. der Flächenwiderstand) geeignet eingerichtet werden kann durch die Geometrie, mit welcher ein solcher metallischer bzw. metallisierter Faden zusammen mit nicht-leitenden Fäden verwoben werden kann: Im Rahmen geeigneter Ausführungsformen der Erfindung liegt es dabei, nicht nur derartige leitende Fäden in Form einer Bindung 1:1 (d.h. sämtliche Fäden metallisch zu beschichten) vorzusehen, sondern auch 1:2, 1:3 oder höher vorzusehen, ergänzend oder alternativ durch Auswahl der Richtung (Schuss, Kette), in welcher überhaupt eine metallische oder metallisierte Faser verwoben werden soll, die Leitfähigkeitseinstellung vorzunehmen (vorgesehen ist insbesondere auch Verweben in beide Richtungen Schuss, Kette).

Zum anderen ist es im Rahmen bevorzugter Realisierungsformen der Erfindung möglich und vorgesehen, die elektrische Leitfähigkeit bzw. den gewünschten niedrigohmigen Flächenwiderstand einzurichten durch eine Metallisierung des Gewebes (d.h. nach dem Verweben), welches typischerweise dann selbst aus nicht-leitenden Polymerfasern besteht (wobei prinzipiell auch hier metallische Fasern eingewoben sein können). Eine derartige metallische Beschichtung des Gewebes kann geeignet durch Sputtern, insbesondere Plasma-Sputtern, erfolgen (z.B. mit Ag, Au, Ti, Mo, Cr, Cu, ITO, ZAO od.dgl.), alternativ durch Bedampfen (Al, Ag, Cu, usw.) oder aber durch nasschemische Verfahren wie Elektrolyse, etwa Abscheiden von Ag, Ni. Typischerweise bewirkt eine derartige Metallisierung des Gewebes eine besonders hohe Leitfähigkeit, welche sich in einem Flächenwiderstand < 10Ω/sq niederschlägt. Weiterbildungsgemäß weist das Gewebe einen Flächenwiderstand < 50Ω/sq, bevorzugt < 20Ω/sq, weiter bevorzugt < 10Ω/sq auf.

Es besteht ein besonderer Vorteil der Erfindung in der hohen Lichtdurchlässigkeit bzw. Transmission des erfindungsgemäß verwendeten Gewebes. Diese lässt sich besonders günstig beeinflussen durch Einstellung der erfindungsgemäß eingerichteten Maschenöffnungen, wobei insbesondere bekannte Verfahren zur Herstellung von Präzisionsgeweben hier günstig angewendet werden können. Zur Realisierung der erfindungsgemäß vorgesehenen Maschenöffnungen bei der erfindungsgemäß offenen Fläche zwischen 20% und 85% hat es sich als besonders bevorzugt herausgestellt, Maschenweiten im Bereich zwischen 30µm und 300µm einzustellen bzw. die Fläche einer jeweiligen Maschenöffnung (bevorzugt konstant über die Fläche) auf einem Bereich zwischen ca. 800µm² und ca. 800.000 µm² einzurichten.

Erfindungsgemäß vorteilhaft ist zudem in der Regel die gesamte Transmission (in %) eines erfindungsgemäß hergestellten Gewebes höher als die offene Fläche des Gewebes; zur so genannten direkten Transmission, nämlich des Lichtdurchtritts durch die Maschen sowie durch transparente Fibern, kommt hinzu eine diffusive Transmission, welche (etwa bei metallisch beschichteten Fasern) eine Reflexion an der Faser oder durch die Faser berücksichtigt, so dass im Ergebnis bei einem Bereich der erfindungsgemäß offenen Fläche zwischen 20% und 85% eine tatsächliche gesamte Transmission zwischen 25% und 95% erreichbar ist.

Erfindungsgemäß weiterbildend ist, dass die Dielektrikumschicht und/oder die aktive Schicht durch Siebdrucken oder als Dünnschicht oder durch ein anderes Beschichtungsverfahren aufgetragen ist, wobei bevorzugt die Dielektrikumsschicht und/oder die aktive Schicht mehrlagig aufgetragen sind. Gemäß bevorzugter Weiterbildungen der Erfindung ist die Dielektrikumsschicht (welche selbst wiederum ggf. mehrlagig aufgetragen sein kann, bevorzugt durch aufeinanderfolgendes Aufbringen, Härten bzw. Trocknen und Aufbringen mindestens einer weiteren Lage) durch Siebdrucken realisiert, ebenso wie die aktive Schicht durch Siebdrucken aufgetragen werden kann. Auch hier ist es von bevorzugten Weiterbildungen der Erfindung umfasst, die aktive Schicht in mehreren sukzessiv durch Siebdrucken (bzw. andere Beschichtungsverfahren) aufgebrachten Lagen auszubilden, insbesondere auch durch Beschichtungsverfahren, die eine kontinuierliche, endlose ("Rolle-zu-Rolle") Beschichtung ermöglichen.

Die vorliegende Erfindung bietet gemäß einer bevorzugten Weiterbildung die Möglichkeit, in äußerst einfacher und eleganter Weise eine EL-Folienanordnung zu schaffen, welche beidseits, d.h. sowohl aus der ersten Elektrodenschicht (Frontelektrode), als auch aus der gegenüberliegenden zweiten Elektrodenschicht (Gegenelektrode) leuchtet und insoweit auf einfachem Weg die Möglichkeit bietet, völlig neue, einseits oder beidseits nutzbare Warn- oder Signalflächen oder dergleichen Anwendungen zu schaffen. Dies geschieht im Rahmen bevorzugter Weiterbildungen der Erfindung dadurch, dass beide Elektrodenschichten in Form des erfindungsgemäß eingesetzten Gewebes realisiert werden, wobei zusätzlich mindestens eine der Elektrodenschichten die Möglichkeit bietet, durch Einbetten in ein geeignetes Material der Dielektrikumsschicht (im noch pastösen bzw. nicht ausgehärteten Zustand) den fertigungstechnischen Vorteil einer festen und zuverlässigen Verbindung mit einfacher und kostengünstiger Herstellbarkeit zu kombinieren. Auch kann die Gegenelektrode polymeres Folienmaterial aufweisen, das weiterbildungsgemäß eine Dicke im Bereich zwischen 30µm und 100µm, bevorzugt zwischen 40µm und 80µm, weiter bevorzugt zwischen 40µm und 60µm, aufweist.

Die aus dem polymeren Folienmaterial realisierte Gegenelektrode ist weiterbildungsgemäß thermisch so stabilisiert, dass sie bei Temperaturen in einem Bereich zwischen 140 °C und 180 °C stabil ist, und/oder weist bevorzugt eine darauf aufgebrachte Metallisierung auf. Die Metallisierung der Gegenelektrode ist weiterbildungsgemäß aus der Gruppe ausgewählt, die die Metalle Ni, Ti, Mo, W, Cr, Cu, Ag, Al, Au aufweist und/oder ist in einer Schichtdicke zwischen 100nm und 10µm, insbesondere zwischen 200nm und 3µm, vorgesehen. Bevorzugt ist die Metallisierung durch Sputtern, insbesondere Plasma-Sputtern, Abscheidung und/oder nasschemische Prozesse, eingeschlossen elektrolytische Prozesse, aufgebracht. Bevorzugt weist die als metallisierte und thermisch stabilisierte Polymerfolie vorliegende Gegenelektrode eine Oberfläche von < 20Ω/sq, bevorzugt < 5Ω/sq, weiter bevorzugt kleiner < 2Ω/sq, auf.

Eine solche Vorgehensweise wird im Rahmen des erfindungsgemäßen Verfahrens und vorteilhaften Ausgestaltungen desselben beansprucht.

Die vorliegende Erfindung ermöglicht damit in potenziell einfacher, eleganter und großserientauglich-kostengünstiger Weise die Herstellung von optoelektronischen Folienanordnungen für eine Vielzahl von (Elektrolumineszenz-) Anwendungen: Je nach der Notwendigkeit, das Leuchtverhalten ein- oder zweiseitig zu nutzen, reicht das Spektrum der möglichen Anwendungen von erfindungsgemäßen Leucht- und/oder Signalvorrichtungen für die Unterhaltungs - und/oder Haushaltselektronik über das Beleuchtungs-, Werbe-, Bau-, Messe-, Architektur-, Sicherheits- oder Verkehrswesen bis hin zu spezifischen Anwendungen im Luftverkehr oder der Militärtechnik.

Weitere Vorteile, Merkmale und Einzelheiten der Erfindung ergeben sich aus der nachfolgenden Beschreibung bevorzugter Ausführungsbeispiele sowie anhand der einzigen Zeichnungen; diese zeigt in:
- Figur 1a, 1b: einen schematischen Schichtaufbau der optoelektronischen Folienanordnung gemäß einer bevorzugten Ausführungsform der vorliegenden Erfindung sowie einer Variante dieser Ausführungsform;
- Figur 2: eine zweite Ausführungsform der vorliegenden Erfindung als gegenüber der ersten Ausführungsform invertierter bzw. in der Schichtenabfolge umgekehrter Realisierungsform; und
- Figur 3a, 3b: eine dritte Ausführungsform der vorliegenden Erfindung in zwei Varianten, korrespondierend zur ersten Ausführungsform, jedoch mit dem Unterschied, dass ein Gewebe unmittelbar mit aktivem Schichtmaterial beschichtet wird.

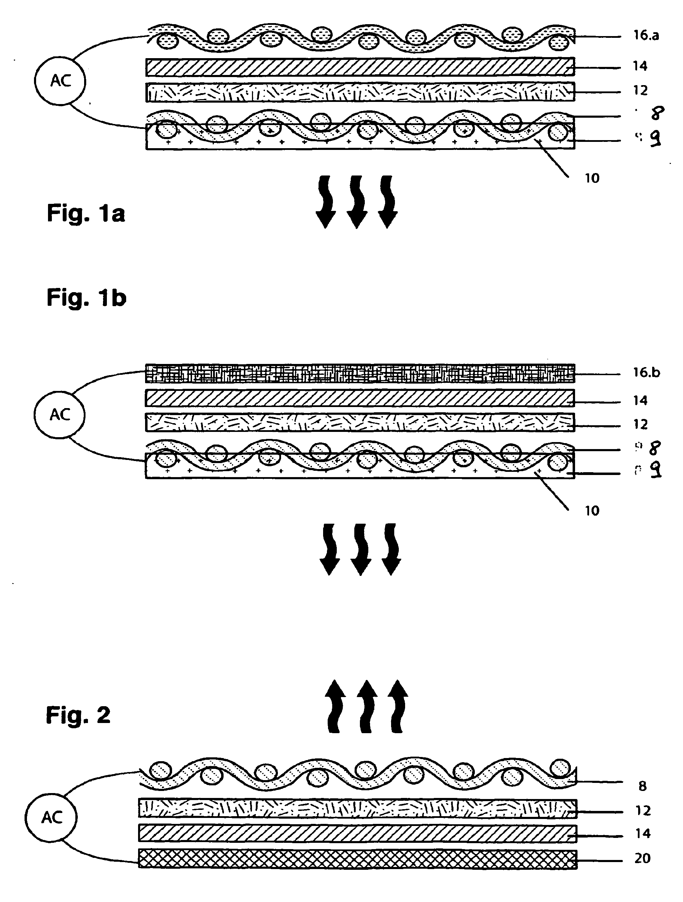

Die Figuren 1a und 1b verdeutlichen in der schematischen Darstellung den Aufbau einer EL-Folienanordnung gemäß einem ersten Ausführungsbeispiel zur Umsetzung der Erfindung:

Ein PET-Gewebematerial 8 (im Beispiel PET 1000 120-23, Herstellerin Sefar, CH-Thal) mit silberbeschichteten PET-Fibern (hier: 120 Fibern/cm, 23Ωm Fadendurchmesser, Dicke der Silberbeschichtung ca. 500nm) wird mit einem transparenten Polymermaterial 9 (hier: einem Acrylharz) versehen, so dass eine erste flächige und transparente Elektrodenschicht 10 realisiert ist. Diese Elektrodenschicht 10 ist im seitlichen Bereich kontaktierbar und weist eine Dicke von typischerweise zwischen 30µm und 200µm auf. Auf diese Weise entsteht eine Lage, die an einer Flachseite nicht leitend, an ihrer andere Flachseite leitend ist.

Auf diese erste Elektrodenschicht, welche in der gezeigten Ausbildung eine Transmission für sichtbares Licht von ca. 50% ermöglicht, wird mit einer aktiven Schicht 12 durch Siebdrucken (oder andere geeignete Beschichtungsverfahren) versehen. In besonders bevorzugter Weise wird diese aktive Schicht auch durch einen Endlosprozess durch geeignete Beschichtungsverfahren ausgetragen, wie etwa Rakelstreichen, Sprühen, Tauchbeschichten oder dergleichen. Die aktive Schicht weist mit Kupfer dotiertes Zinksulfid, zusätzlich beigemischt Al₂O₃ als weitere Komponente, und aufbereitet als siebdruckfähige Tinte/Paste, auf. Diese Tinte (typischerweise im Handel erhältlich als Produkt E80-02SB, Hersteller Mobichem) wird einschichtig so aufgetragen, dass eine Dicke der trockenen aktiven Schicht 12 30µm bis 80µm beträgt.

Auf diese aktive Schicht wird, wiederum durch Siebdrucken (oder ein anderes alternatives Beschichtungsverfahren, s.o.), eine dielektrische Schicht (Dielektrikumsschicht 14) aufgetragen. Dieses Auftragen erfolgt dabei in zwei Stufen, wobei zunächst eine erste Lage durch Siebdrucken aufgebracht wird (typische verwendete Paste: Typ D80-01, Hersteller Mobichem, eine übliche Bariumtitanat-Paste, wobei verwendete Siebdruckpasten durch geeignete Lösungsmittel entsprechend den Beschichtungsanforderungen verdünnt werden können, typischerweise erfolgt eine Verdünnung von 0 bis 50%). Das Auftragen erfolgt so, dass nach dem Trocknen (110° bis 130°, 20 bis 30 Min.) diese erste Lage eine Schichtdicke von ca. 5 bis 40µm aufweist. Auf diese Lage wird dann eine zweite Schicht des gleichen dielektrischen Materials durch Siebdrucken (oder ein anderes Beschichtungsverfahren) aufgebracht, wobei nach dem Auftragen (wiederum zum Erreichen einer vergleichbaren Schichtdicke) in das noch ungetrocknete Material der zweiten Lage ein silber-metallisiertes PET-Gewebe 16a (entsprechend dem für die Elektrodenschicht 10 verwendeten Typ) eingelegt wird, so dass ein (teilweises) Eindringen des Gewebematerials in das aufgebrachte dielektrische Material erfolgt. Erst dann (ggf. mit einem zwischengeschalteten Aufwalzen oder Anpressen des Gewebematerials für die zweite Elektrodenschicht 16a) erfolgt das Trocknen unter Wärmezufuhr.

In einer weiteren, alternativen Ausführungsform werden eine erste sowie eine zweite dielektrische Schicht aufeinanderfolgend aufgetragen, nach dem Trocknen einer vorhergehenden Schicht. Jede dielektrische Schicht (14) wird mit den selben Prozessbedingungen wie oben beschrieben durch Siebdruck oder ein sonstiges Beschichtungsverfahren aufgetragen, sodass eine getrocknete Schicht eine durchschnittliche Dicke im Bereich zwischen etwa 5µm und 40µm besitzt. Eine metallisierte Schicht (16b) wird danach auf die (zweite) dielektrische Schicht aufgetragen, nachdem diese getrocknet ist. Eine derartige metallisierte Schicht auf der Mehrschichtstruktur kann etwa geeignet durch Plasmasputtem (beispielsweise mittels Ag, Au, Ti, Mo, Cr, Cu, ITO, ZAO oder dergleichen) stattfinden, alternativ durch Abscheidung (Al, Ag, Cu, usw.). Typischerweise erfolgt die Metallisierung mittels Silber einer Dicke im Bereich zwischen 25 und 200nm. Der Flächenwiderstand dieser Schicht sollte bevorzugt relativ niedrig, insbesondere < 5Ω/sq liegen. Durch diese zusätzliche Ausführungsform wird der Vorteil homogener Metalldicke realisiert, was zu einer homogeneren Helligkeitsverteilung des Endprodukts führt.

Geeignet wird die erste Elektrodenschicht und die zweite Elektrodenschicht im Randbereich elektrisch kontaktiert; die Figur 1a bzw. 1 b verdeutlicht dann die symbolische Beaufschlagung mit einem Wechselspannungssignal zum Betreiben der Vorrichtung, welche aus beiden Elektrodenflächen Licht abstrahlt.

Bei dem in der Variante der Figur 1a beschriebenen ersten Ausführungsbeispiel erfolgt das Beschichten des Dielektrikums in zwei Schritten, wie beschrieben. Dabei wird bevorzugt das zweite metallisierte PET-Gewebe 16a in (optischer) Abstimmung mit dem Gewebe der transparenten Elektrode 10 gewählt und ausgerichtet, um einen (nachteiligen) Moiréeffekt zu vermeiden. Typischerweise geschieht dies durch das Ausrichten der beiden Gewebe relativ zueinander in einem vorbestimmten Winkel.

Die Figur 1 b beschreibt einen zusätzlichen und alternativen Weg zur Realisierung des ersten Ausführungsbeispiels, wobei die zweite dielektrische Schicht 14 in derselben Weise wie die erste Schicht aufgebracht wird. Allerdings wird eine metallisierte Beschichtung 16b auf die zweite dielektrische Schicht gebracht, nachdem diese getrocknet wurde. Eine derartige metallische Schicht kann geeignet durch Plasmasputtern (z.B. mit Ag, Au, Ti, Nu, Cr, Cu, ITO, ZAO oder dergleichen) erfolgen, alternativ durch Abscheidung (Al, Ag, Cu, usw.). ITO ist allerdings weniger bevorzugt. Typischerweise wird die Metallisierung aus Silber einer Dicke im Bereich zwischen 20 und 200nm realisiert, mit einem Flächenwiderstand der relativ niedrig bei < 5Ω/sq liegt. Vörteile sind homogene Metalidicke, damit größere Homogenität der Helligkeit des Endprodukts.

Ein Vorteil des vorbeschriebenen ersten Ausführungsbeispiels liegt darin, dass relativ raue Schichtübergänge entstehen. Dies wirkt sich positiv auf die Lichtbrechung bzw. die Lichtverteilung in der Schichtanordnung aus und verhindert Lichtfallen.

Nachfolgend wird anhand der Figur 2 eine zweite Ausführungsform der vorliegenden Erfindung erläutert, welche auch als "invertierte" Variante verstanden werden kann, da gegenüber dem vorbeschriebenen ersten Ausführungsbeispiel die Abfolge der Schichten umgekehrt ist. Genauer gesagt wird die Gegenelektrode zuerst mit Dielektrikum beschichtet, dann die aktive Schicht aufgetragen, worauf dann die transparente Elektrode aufgebracht wird.

Diesbezüglich zeigt die Figur 2 in der schematischen Anordnung, wie die rückwärtige Elektrode (Gegenelektrode) aus einem leitenden Film 20 (typischerweise einem zum Erreichen gewünschter Leitfähigkeit metallisierten Folienmaterial) realisiert ist. Diese Folie wird thermisch stabilisiert, damit sie (nach Trocknen) für aufzubringende Paste stabil ist; derartiges Thermo-Stabilisieren erfolgt bis zu Temperaturbereichen von 130°C bis 180°C. Die Folie (Film) 20 ist zum Realisieren einer sogenannten Rückfolien-Lampe (foil back structured lamp) dünn und flexibel, typischerweise erreichbar durch eine PET-Folie einer durchschnittlichen Dicke zwischen 40µm und 100µm (bevorzugte Dicke ca. 50µm). Die geeignete Metallisierung erfolgt in Richtung auf einen Flächenwiderstand typischerweise < 50Ω/sq, weiter bevorzugt < 20Ω/sq, noch weiter bevorzugt < 10Ω/sq.

Darauf aufgebracht ist eine (einlagige oder zweilagige) dielektrische Schicht 14. Das Aufbringen der dielektrischen Schicht(en) erfolgt in derselben Weise wie oben im Zusammenhang mit dem ersten Ausführungsbeispiel beschrieben, wobei wiederum in geeigneter Weise die Siebdruckpaste verdünnt werden kann und in der vorbeschriebenen Weise getrocknet wird.

Nach dem Trocknen der dielektrischen Schicht(en) wird die aktive Schicht 12 aufgebracht. Diese entspricht wiederum der oben im Zusammenhang mit dem ersten Ausführungsbeispiel beschriebenen (entsprechende Siebdruckpaste, Lieferant, Herstellungs- und Trocknungsschritte, Schichtung). Auf diese Schicht wird ein mit Silber metallisiertes PET-Gewebe 8 (entsprechend der Elektrodenschicht) aufgebracht, und zwar in das noch nicht vollständig getrocknete Material der letzten Beschichtung, sodass eine (teilweise) Durchdringung des Gewebematerials mit dem aktiven Material erfolgt. Danach wird die Anordnung getrocknet (ggf. nach einem Auf- bzw. Einpressen der zweiten Elektrodenschicht 8, falls notwendig). In diesem Ausführungsbeispiel wird durch das Einbringen des Gewebes vorteilhaft erreicht, dass die EL-Partikel der aktiven Schicht sehr guten Kontakt mit dem Gewebe ausbilden, jedoch nicht durch das Gewebe hindurch dringen (da in diesem Fall diejenigen EL-Partikel der aktiven Schicht, die nicht zwischen den beiden Elektroden liegen, kein Licht emittieren und entsprechend nachteilig dunkle Flecken oder Inhomogenitäten in der Lichtverteilung bewirken). Wiederum vorteilhaft bei diesem zweiten Ausführungsbeispiel ist das (jeweilige) Aufbringen der Beschichtungen in endloser Form, sodass insoweit großserientauglich und effizient gefertigt werden kann. Insbesondere unter diesem Gesichtspunkt ist die am zweiten Ausführungsbeispiel vorstehend erläuterte Realisierungsform vorteilhaft.

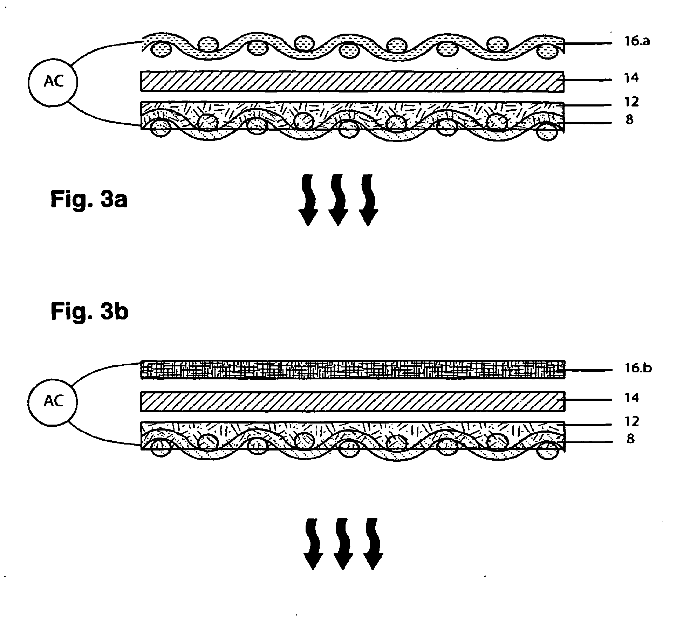

Schließlich soll im Zusammenhang mit dem dritten Ausführungsbeispiel anhand der Figuren 3a und 3b eine Variante zum ersten Ausführungsbeispiel erläutert werden. Hier wird dieselbe Reihenfolge der Schichten wie im ersten Ausführungsbeispiel gewählt, wobei der Unterschied darin liegt, dass anstelle einer transparenten Beschichtung des Gewebes mit darauf aufgebrachter aktiver Schicht beim dritten Ausführungsbeispiel das Gewebe direkt (unmittelbar) mit der (EL-)aktiven Schicht beschichtet wird.

Dies ist anhand der Figuren 3a bzw. 3b schematisch zu erkennen. So wird ein PET-Gewebematerial 8 (wiederum beispielsweise PET 1000 100-23, Lieferant SEFAR, CH-Thal). mit Silber-beschichtetem PET-Fibern (hier: 120 Fibern/cm, 23µm Fadendurchmesser, Dicke der Silberbeschichtung ca. 500nm) mit der aktiven Schicht (direkt) versehen, sodass das Gewebe teilweise in die Schicht auf einer Seite und vollständig auf der anderen Seite eingebettet ist.

Danach wird die dielektrische Schicht in derselben Weise aufgetragen, wie vorstehend im Zusammenhang mit den Figuren 1a bzw. 1b beschrieben, wobei wiederum die zwei Varianten zum Realisieren der Gegenelektrode geeignet sind.

Die vorbeschriebenen Ausführungsformen sind nicht als abschließend zu verstehen, vielmehr liegt es im Rahmen der vorliegenden Erfindung, die verschiedenen Parameter, Materialien und Prozessbedingungen zu variieren.

So liegt es im Rahmen erfinderischer Ausgestaltungen, die jeweiligen Prozessschritte zum Auftragen, Trocknen, usw., insbesondere auch das Vorsehen mehrerer Lagen sowohl für die Dielektrikumsschicht, als auch für die aktive Schicht aus dem elektrolumineszenten Material, geeignet einzustellen, um insoweit dann einem Anwendungsfall gerecht zu werden. Wie in der Beschreibungseinleitung erläutert, bestehen zahlreiche Möglichkeiten, Lichtfarbe, Helligkeit/Durchlässigkeit, mechanische Belastbarkeit und weitere Parameter, insbesondere durch Einstellung und Auswahl geeigneter Gewebeeigenschaften vorzubestimmen. Dazu gehört die Auswahl und Einstellung geeigneter Faserdicken (Fiberdicken) sowie Maschenweiten, ebenso wie Auswahl und Ausgestaltung einer geeigneten Beschichtung, die Auswahl und Einrichtung eines vorteilhaft auszuwählenden Polymermaterials, insbesondere für die erste Elektrodenschicht und/oder das Einstellen der erwähnten Prozessparameter zur Realisierung von Dielektrikums- und/oder aktiver Schicht.

Im Rahmen bevorzugter Weiterbildungen des beschriebenen Verfahrens und/oder zur Realisierung atternativer Ausbildungen der erfindungsgemäß herzustellenden optoelektronischen Folienanordnung ist es sinnvoll, durch Fixationsmaßnahmen (etwa das Einspannen des Gewebes für die zweite Elektrodenschicht in einen Rahmen) die Relativpositionen und/oder eine Gewebevorspannung vor dem Einbringen zu kontrollieren. Wird etwa als Gegenelektrode metallisiertes PET-Gewebe (16a) gewählt, sollten die Gewebeeigenschaften im Hinblick auf die Elektrodenschicht 10 sorgfältig bestimmt bzw. bemessen sein, um etwa einen nachteiligen Moiréeffekt zu vermeiden. Eine typische Vorgehensweise hier besteht darin, das zweite metallisierte Gewebe unter einem vorbestimmten Winkel im Hinblick auf die erste Elektrodenschicht aufzubringen.

Im Ergebnis entsteht durch die vorliegende Erfindung in überraschend einfacher und eleganter Weise eine variable, flexible und kostengünstig herzustellende Elektrolumineszenz-Folienanordnung, welche die EL-Technologie potenziell einem noch weiteren Anwendungsspektrum zugänglich machen kann. Auch kann diese Folienanordnung endlos ("Rolle-auf-Rolle") hergestellt werden und vorteilhaft große Emissionsflächen mit hoher Helligkeit- bzw. Strahlungshomogenität realisieren; ein zusätzlicher Vorteil ist die Verwendbarkeit vergleichsweise hoher Grenzfrequenzen und Steuerspannungen.

## Patentansprüche

1. Optoelektronische Folienanordnung mit
einer ersten flächigen Elektrodenschicht (10),
einer zweiten flächigen Elektrodenschicht (16) als Gegenelektrode zur ersten flächigen Elektrodenschicht,
einer Dielektrikumsschicht zwischen den Elektrodenschichten und einer der Dielektrikumsschicht (14) benachbart und zwischen den Elektrodenschichten vorgesehenen aktiven Schicht (12) aus einem elektrolumineszenten Material, wobei
die erste und/oder die zweite Elektrodenschicht lichtdurchlässig und TCO - oder ITO-frei, mittels eines elektrisch leitende Fasern aufweisenden Gewebes realisiert ist,
**dadurch gekennzeichnet, dass** die Fasern einen Faserdurchmesser zwischen 18µm und 32µm, aufweisen und eine Maschenweite von Maschenöffnungen des Gewebes im Bereich zwischen 50µm und 70µm liegt.

2. Folienanordnung nach Anspruch 1, **dadurch gekennzeichnet, dass** das Gewebe mit einer ein transparentes, elektrisch nicht-leitendes Polymermaterial aufweisenden Beschichtung so versehen ist, dass die Fasern zumindest teilweise von dem Polymermaterial umgeben sind.

3. Folienanordnung nach einem der Anspruch 2, **dadurch gekennzeichnet, dass** das Polymermaterial aus der Gruppe ausgewählt ist, welches ein Acrylharz, Silikon, ein Fluorpolymer, PU, PEN, PI, PET, PA, EVA sowie Mischungen von diesen, insbesondere mit SiOx oder anderen anorganischen Materialien, aufweist.

4. Folienanordnung nach einem der Ansprüche 1 bis 3, **dadurch gekennzeichnet, dass** das Gewebe Maschenöffnungen aufweist, die eine offene Fläche von 20% bis 95%, bevorzugt zwischen 40% und 60%, realisieren.

5. Folienanordnung nach einem der Ansprüche 1 bis 4, **dadurch gekennzeichnet, dass** die erste und die zweite Elektrodenschicht als lichtdurchlässig Gewebeschichten zum Realisieren einer beidseits lichtimitierenden EL-Folienanordnung ausgebildet sind.

6. Folienanordnung nach einem der Ansprüche 1 bis 5, **dadurch gekennzeichnet, dass** die erste und die zweite Elektrodenschicht ITO-frei realisiert ist.

7. Verfahren zum Herstellen einer optoelektronischen Folienanordnung, insbesondere Folienanordnung nach einem der Ansprüche 1 bis 6, **gekennzeichnet durch** die Schritte:
- zumindest teilweises Einbetten eines elektrisch leitende Fasern aufweisenden Gewebes in eine transparente, elektrisch nicht-leitende Polymerschicht zum Herstellen einer TCO-freien, insbesondere ITO-freien, ersten Elektrodenschicht;
- Aufbringen einer aktiven Schicht aus elektrolumineszentem Material auf die erste Elektrodenschicht, insbesondere mittels Siebdrucken;
- Aufbringen einer dielektrischen Schicht auf die aktive Schicht, insbesondere mittels Siebdrucken;
- Aufbringen einer zweiten Elektrodenschicht als Gegenelektrode zur ersten Elektrodenschicht auf die dielektrische Schicht, wobei das Gewebe so gewählt st, dass die Fasern einen Faserdurchmesser zwischen 18µm und 32µm, aufweisen und eine Maschenweite von Maschenöffnungen des Gewebes im Bereich zwischen 50µm und 70µm liegt.

8. Verfahren nach Anspruch 7, **dadurch gekennzeichnet, dass** das Aufbringen der zweiten Elektrodenschicht das zumindest teilweise Einbringen eines elektrisch leitende Fasern aufweisenden Gewebes in die dielektrische Schicht so aufweist, dass die Fasern der zweiten Elektrodenschicht in noch nicht ausgehärtetes oder getrocknetes Material der dielektrischen Schicht gebracht werden.

9. Verfahren nach Anspruch 7, **dadurch gekennzeichnet, dass** die zweite Elektrodenschicht auf die getrocknete dielektrische Schicht durch einen Metallisierungsvorgang, insbesondere mittels Plasmasputtern oder Gasfasenabscheidung, erfolgt.

10. Verfahren nach einem der Ansprüche 7 bis 9, **gekennzeichnet durch** das Verformen der ersten Elektrodenschicht, insbesondere das Anpassen der ersten Elektrodenschicht an einen nicht planen Träger.

11. Verfahren nach einem der Ansprüche 7 bis 10, **gekennzeichnet durch** das Einstellen einer elektrischen Leitfähigkeit und/oder Transparenz und/oder Farbe der ersten und/oder zweiten Elektrodenschicht.

12. Verfahren nach Anspruch 7 oder 11, **dadurch gekennzeichnet, dass** eine erste und eine zweite dielektrische Schicht auf eine thermisch stabilisierte und metallisierte Polymerfolie als Gegenelektrode, insbesondere durch einen kontinuierlichen, endlosen Beschichtungsprozess, aufgebracht wird, woraufhin die aktive Schicht und eine elektrisch leitendende Fasern aufweisende Gewebeschicht aufgebracht wird.

13. Verfahren nach Anspruch 12, **dadurch gekennzeichnet, dass** das Aufbringen der die elektrisch leitenden Fasern aufweisenden Gewebeschicht das zumindest teilweise Einbetten der Fasern in das noch nicht gehärtete oder getrocknete Material der aktiven Schicht aufweist.

14. Verfahren nach Anspruch 12 oder 13, **dadurch gekennzeichnet, dass** das Auftragen der aktiven Schicht mehrlagig oder mehrschichtig, insbesondere durch aufeinanderfolgende Beschichtungs- und Härte- bzw. Trocknungsvorgänge einzelner Schichten, erfolgt.

## Claims

1. Optoelectronic film arrangement, comprising a first planar electrode layer (10), a second planar electrode layer (16) as a counter electrode to the first planar electrode layer, a dielectric layer between the electrode layers, and an active layer (12) of an electroluminescent material provided adjacent to the dielectric layer (14) and between the electrode layers, the first and/or the second electrode layer being implemented so as to be translucent and free of TCOs or ITO by means of a fabric having electrically conductive fibres, **characterised in that** the fibres have a fibre diameter of between 18 µm and 32 µm and a mesh size of mesh openings of the fabric in the range of between 50 µm and 70 µm.

2. Film arrangement according to claim 1, **characterised in that** the fabric is provided with a coating having a transparent, electrically non-conductive polymer material, such that the fibres are at least partially surrounded by the polymer material.

3. Film arrangement according to claim 2, **characterised in that** the polymer material is selected from the group comprising an acrylic resin, silicon, a fluoropolymer, PU, PEN, PI, PET, PA, EVA, and mixtures thereof, in particular with SiOx or other inorganic materials.

4. Film arrangement according to any of claims 1 to 3, **characterised in that** the fabric has mesh openings which implement an open surface area of from 20 % to 95 %, preferably of between 40 % and 60 %.

5. Film arrangement according to any of claims 1 to 4, **characterised in that** the first and the second electrode layers are configured as translucent fabric layers in order to implement an EL-film arrangement that emits light on both sides.

6. Film arrangement according to any of claims 1 to 5, **characterised in that** the first and the second electrode layers are implemented so as to be free of ITO.

7. Method for producing an optoelectronic film arrangement, in particular a film arrangement according to any of claims 1 to 6, **characterised by** the steps of: at least partially embedding a fabric having electrically conductive fibres into a transparent, electrically non-conductive polymer layer in order to produce a first electrode layer that is free of TCOs, in particular free of ITO; applying an active layer of an electroluminescent material onto the first electrode layer, in particular by means of screen printing; applying a dielectric layer onto the active layer, in particular by means of screen printing; applying a second electrode layer as a counter electrode to the first electrode layer onto the dielectric layer, wherein the fabric is selected such that the fibres have a fibre diameter of between 18 µm and 32 µm, and a mesh size of mesh openings of the fabric lies in the range of between 50 µm and 70 µm.

8. Method according to claim 7, **characterised in that** the application of the second electrode layer comprises the at least partial introduction into the dielectric layer of a fabric having electrically conductive fibres, such that the fibres of the second electrode layer are introduced into the not-yet-cured or -dried material of the dielectric layer.

9. Method according to claim 7, **characterised in that** the second electrode layer is applied onto the dried dielectric layer by a metallisation process, in particular by means of plasma sputtering or vapour deposition.

10. Method according to any of claims 7 to 9, **characterised by** the shaping of the first electrode layer, in particular by the adaptation of the first electrode layer to a non-planar carrier.

11. Method according to any of claims 7 to 10, **characterised by** the adjustment of an electrical conductivity and/or transparency and/or colour of the first and/or second electrode layer.

12. Method according to either claim 7 or claim 11, **characterised in that** a first and a second dielectric layer are applied onto a thermally stabilised and metallised polymer film as a counter electrode, in particular by means of a continuous, endless coating process, whereupon the active layer and a fabric layer having electrically conductive fibres are applied.

13. Method according to claim 12, **characterised in that** the application of the fabric layer having electrically conductive fibres comprises the at least partial embedding of the fibres into the not-yet-cured or -dried material of the active layer.

14. Method according to either claim 12 or claim 13, **characterised in that** the application of the active layer takes place in a multi-layered or a multi-coated manner, in particular by means of successive coating and curing and/or drying processes of individual layers.

## Revendications

1. Ensemble optoélectronique stratifié présentant
une première couche plate d'électrode (10),
une deuxième couche plate d'électrode (16) qui sert de contre-électrode pour la première couche plate d'électrode,
une couche de diélectrique disposée entre les couches d'électrode et
une couche active (12) en matériau électroluminescent, prévue au voisinage de la couche diélectrique (14) et entre les couches d'électrode,
la première et/ou la deuxième couche d'électrode étant transparentes à la lumière, exemptes de TCO ou d'ITO et réalisées au moyen d'un tissu présentant des fibres électriquement conductrices,
**caractérisé en ce que** les fibres ont un diamètre compris entre 18 µm et 32 µm et **en ce que** les ouvertures des mailles du tissu ont une taille comprise entre 50 µm et 70 µm.

2. Ensemble stratifié selon la revendication 1, **caractérisé en ce que** le tissu est doté d'un revêtement qui présente un matériau polymère transparent, électriquement non conducteur de telle sorte que les fibres sont entourées au moins en partie par le matériau polymère.

3. Ensemble stratifié selon la revendication 2, **caractérisé en ce que** le matériau polymère est sélectionné dans l'ensemble formé des résines acryliques, des silicones, des polymères fluorés, du PU, du PEN, du PI, du PET, du PA, de l'EVA et de leurs mélanges, en particulier avec du SiOx ou d'autres matériaux minéraux.

4. Ensemble stratifié selon l'une des revendications 1 à 3, **caractérisé en ce que** le tissu présente des ouvertures dont la surface ouverte représente de 20 % à 95 % et de préférence de 40 % à 60 % de la surface du tissu.

5. Ensemble stratifié selon l'une des revendications 1 à 4, **caractérisé en ce que** la première et la deuxième couche d'électrode sont configurées comme couches transparentes de tissu, de manière à réaliser un ensemble stratifié EL qui imite la lumière sur ses deux faces.

6. Ensemble stratifié selon l'une des revendications 1 à 5, **caractérisé en ce que** la première et la deuxième couche d'électrode sont réalisées sans ITO.

7. Procédé de fabrication d'un ensemble optoélectronique stratifié, en particulier d'un ensemble stratifié selon l'une des revendications 1 à 6, le procédé étant **caractérisé par** les étapes qui consistent à :
incorporer au moins partiellement un tissu présentant des fibres électriquement conductrices dans une couche transparente de polymère électriquement non conducteur en vue de réaliser une première couche d'électrode exempte de TCO et en particulier exempte d'ITO,
appliquer une couche active de matériau électroluminescent sur la première couche d'électrode, en particulier par sérigraphie,
appliquer une couche diélectrique sur la couche active, en particulier par sérigraphie et
appliquer sur la couche diélectrique une deuxième couche d'électrode qui sert de contre-électrode à la première couche d'électrode, le tissu étant sélectionné de telle sorte que les fibres présentent un diamètre compris entre 18 µm et 32 µm et que les ouvertures des mailles du tissu aient une taille comprise entre 50 µm et 70 µm.

8. Procédé selon la revendication 7, **caractérisé en ce que** l'application de la deuxième couche d'électrode recourt à l'incorporation au moins partielle d'un tissu qui présente des fibres électriquement conductrices dans la couche diélectrique en plaçant les fibres de la deuxième couche d'électrode dans le matériau encore non durci ou séché de la couche diélectrique.

9. Procédé selon la revendication 7, **caractérisé en ce que** l'application de la deuxième couche d'électrode sur la couche diélectrique séchée s'effectue par une opération de métallisation, en particulier par pulvérisation au plasma ou dépôt en phase gazeuse.

10. Procédé selon l'une des revendications 7 à 9, **caractérisé par** la déformation de la première couche d'électrode, en particulier par l'adaptation de la première couche d'électrode à un support non plan.

11. Procédé selon l'une des revendications 7 à 10, **caractérisé par** l'ajustement de la conductivité électrique et/ou de la transparence et/ou de la couleur de la première et/ou de la deuxième couche d'électrode.

12. Procédé selon l'une des revendications 7 ou 11, **caractérisé en ce qu'**une première couche et une deuxième couche diélectriques sont appliquées sur une feuille polymère stabilisée thermiquement et métallisée qui sert de contre-électrode, en particulier par une opération de revêtement continue sans fin, suite à quoi la couche active et une couche de tissu présentant des fibres électriquement conductrices sont appliquées.

13. Procédé selon la revendication 12, **caractérisé en ce que** l'application de la couche de tissu présentant des fibres électriquement conductrices s'effectue par incorporation au moins partielle des fibres dans le matériau non encore durci ou séché de la couche active.

14. Procédé selon l'une des revendications 12 ou 13, **caractérisé en ce que** l'application de la couche active s'effectue en plusieurs couches ou épaisseurs, en particulier par des opérations successives d'application et de durcissement ou de séchage de différentes couches.
